# EUROPEAN PATENT SPECIFICATION

(11) **EP 0 807 325 B1**
(45) Date of publication and mention of the grant of the patent: **21.04.1999**
(21) Application number: 96903688.8
(22) Date of filing: 30.01.1996
(51) Int. Cl.: H01R 9/09

(54) **PRESS-FIT CONNECTING PIN AND ELECTRONIC DEVICE USING THE SAME**
EINPRESSSTIFT UND DAMIT VERSEHENE ELEKTRONISCHE VORRICHTUNG
BROCHES DE CONNEXION S'EMMANCHANT A FORCE ET DISPOSITIF ELECTRONIQUE LES UTILISANT

(30) Priority: 31.01.1995 JP 34518/95
(43) Date of publication of application: 19.11.1997
(73) Proprietor: THE WHITAKER CORPORATION, Wilmington, Delaware 19808 (US)
(72) Inventor: TAKENAKA, Noriaki, Kawasaki-shi, Kanagawa 133 (JP); KUROKAWA, Noriharu, Kawasaki-shi, Kanagawa 228 (JP); SASAKI, Takinori, Kawasaki-shi, Kanagawa 257 (JP)
(74) Representative: Warren, Keith Stanley
(86) International application number: US9601048
(87) International publication number: WO9624175

(56) References cited:
- EP-A- 0 340 574
- FR-A- 966 327
- US-A- 3 444 617
- US-A- 3 827 004
- US-A- 5 002 507

## Description

The present invention concerns a pin that is press-fitted and connected to electrical terminals, especially plated through-holes, and electronic devices such as pin grid arrays (PGA's), IC devices and electrical connectors or the like which use such a press-fit connecting pin.

Electronic circuit parts that are attached to circuit boards during use, such as PGA's, IC devices, electrical connectors, switches and the like (hereafter referred to collectively as "electronic devices") have numerous terminals or pins. Such pins are connected to conductive pads or conductive paths of circuit boards during use.

In the case of such electronic devices, the number of pins has increased, and the pins have been installed at a higher density (smaller pitch), as the size of electronic equipment has been reduced and the performance of such equipment has been improved.

Soldering is a common technique used to effect electrical connection of such numerous high-density pins to circuit boards. In the case of high-density pins, however, not only is soldering difficult but a drop in reliability caused by solder bridges or the like also becomes a problem. Furthermore, it is extremely difficult to remove electronic devices once these devices have been soldered. Accordingly, such soldered devices are difficult to maintain and service.

In order to overcome the drawbacks of soldering such as these, direct electrical connections achieved by press-fitting pins into circuit boards that have plated through-holes have been proposed. Such techniques have spread widely, especially in the field of communications equipment.

A compliant pin terminal known as the ACTION PIN® terminal has been commercially marketed by AMP Incorporated as one type of such press-fit connecting pin. This compliant pin is constructed so that portions of the shaft of the pin are sheared in the axial direction and mutually offset along the shear surfaces, as disclosed, for example, in U.S. Patent No. 4,186,982. Accordingly, this pin can be press-fitted relatively smoothly against the inside walls of plated through-holes, so that highly reliable electrical connections can be achieved and maintained with a large contact pressure and without damaging the plating layer. A similar compliant pin is also disclosed in Japanese Utility Model Application Kokai No. 58-14683, and a pin split into three parts is disclosed in Japanese Utility Model Application Kokai No. 60-45463 and elsewhere.

On the other hand, compliant pins or press-fit pins that have been given a deformable cross-sectional shape by applying pressure or mechanical working without shearing the shaft portion of the pin are disclosed in Japanese Patent Publication No. 62-5575, Japanese Utility Model Publication No. 58-154572, Japanese Utility Model Publication No. 60-172370, Japanese Utility Model Publication No. 58-157974, Japanese Patent No. 58-172881 and elsewhere.

The conventional compliant pins described above are sufficient for certain specified applications but are difficult or impossible to use in the case of small-size high-density pins with extremely slender shafts, such as high-density pins with extremely slender shafts, such as those having a diameter of approximately 0.4 mm, which are required by recent electronic devices. The reasons for this are as follows:

First, in the case of compliant pins in which the shaft portion is sheared or offset so that the shaft portion is split into two or three parts as described above, such working cannot be applied to fine pins that have a diamter of approximately 0.4 mm. Futhermore, when conventional compliant pins that have been worked so that the cross-sectional shape of the pin is deformable are used in through-holes which have a diameter of approximately 0.4 mm, the amount of deformation is small so that an excessive amount of insertion force is required for press-fitting. As a result, the pins themselves undergo buckling deformation. Furthermore, the plating layers of the through-holes may be destroyed or, depending on the dimensional working tolereances of the through-holes and pins, it may be impossible to obtain electrical connections of sufficiently high reliability.

U.S. Patent No. 3,827,004 discloses a press-fit connecting pin according to the preamble of claim 1 or claim 2 and including a shaft having deformable fins or strips projecting therefrom at separate locations with respect to one another and dimensioned to engage the inside walls of the through-hole when inserted therein. The shaft carrying the fins is substantially square and includes pairs of collapsible fins that bend toward each other when the pin is inserted into a through-hole.

An object of the present invention is to provide a press-fit connecting pin [a] that can be press-fitted relatively easily in through-holes which have a relatively large dimensional tolerance, [b] that makes it possible to achieve a highly reliable electrical connection, and [c] that can be used in the case of small-size high-density pins.

Another object of the present invention is to provide an electronic device that has numerous small-size high-density press-fit connecting pins and that has press-fit connecting pins with a low insertion force and a high degree of reliability.

In order to eliminate the above mentioned drawbacks of conventional press-fit connecting pins and achieve the above mentioned technical objects, the invention consists in a press-fit connecting pin as defined in claim 1 or 2.

Furthermore, the invention consists in an electronic device characterized by the fact that the device includes numerous press-fit connecting pins having the construction defined in claim 1 or 2 so that highly reliable electrical connections with plated through-holes formed in circuit boards can be achieved by means of a relatively low insertion force.

Preferred embodiments of the press-fit connecting pin of the present invention and an electronic device using the same will be described in detail with reference to the accompanying drawings in which:-

FIGURE 1 is a front view that shows the overall construction of a preferred embodiment of the press-fit connecting pin of the present invention and the connection of this pin to a circuit board.

FIGURE 2 is a cross sectional view of one example of the press-fit connecting portion of the press-fit connecting pin shown in Figure 1.

FIGURE 3 is a cross sectional view that shows the press-fit connecting pin of Figures 1 and 2 press-fitted in the through-hole of a circuit board.

FIGURE 4 is cross-sectional view of a first alternative embodiment of the press-fit connecting portion of the pin.

FIGURE 5 is a cross-sectional view of a second alternative embodiment of the press-fit connecting portion of the pin.

FIGURE 6 is a cross-sectional view of a third alternative embodiment of the press-fit connecting portion of the pin.

FIGURE 7 is a cross-sectional view of a fourth alternative embodiment of the press-fit connecting portion of the pin.

FIGURE 8 is a front view of an electronic device embodying the present invention.

FIGURE 9 is a bottom view of the device of Figure 8.

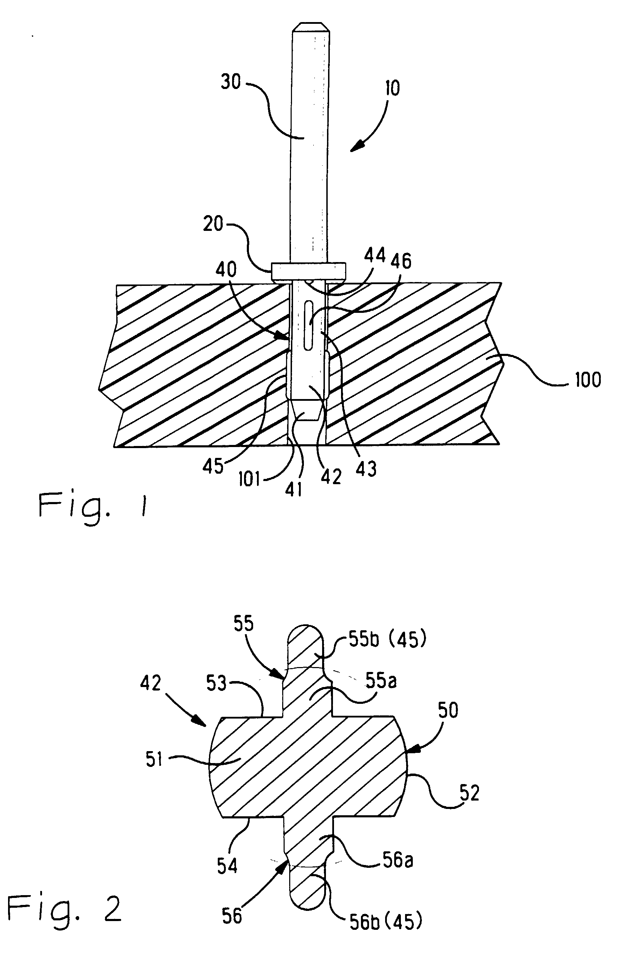

First, the overall construction of a press-fit connecting pin constituting a preferred embodiment of the present invention will be described with reference to Figure 1. Figure 1 is a side view of a press-fit connecting pin 10. This press-fit connecting pin 10 is preferably made of a copper alloy such as zirconium-copper or the like or other electrically conductive alloy such as one sold under the trade mane of KOVAR®. The overall shape of the pin is substantially cylindrical. The pin 10 has a large-diameter flange portion 20 located roughly midway along the pin; furthermore, the pin 10 has a substantially uniform cylindrical portion 30 on one side of the flange portion 20 and a press-fit connecting portion 40, which is press-fitted into a plated through-hole 101 formed in a circuit board 100, on the other side of the flange portion 20. In this specific embodiment, the thickness of the circuit board 100 is approximately 2.0 mm, and the internal diameter of the through-hole 101 is 0.45 ± 0.05 mm. The overall length of the press-fit connecting pin 10 is 4.8 nm, the length and diameter of the cylindrical portion 30 are 3.1 mm and 0.45 mm, respectively, the diameter of the flange portion 20 is 0.9 mm, and the length of the press-fit connecting portion 40 is 1.7 mm. Of course, it should be noted that these dimensions and shapes may be appropriately selected in accordance with the intended use of the pin.

Next, the press-fit connecting portion 40 that constitutes the essential part of the press-fit connecting pin 10 of the present invention will be described. The press-fit connecting portion 40 in this specific embodiment has [a] a tapered end section 41, [b] a first section 42 and second section 43 that form a continuation of the end section 41, each having a length of approximately 0.6 mm, and if necessary, [c] a plurality of radial ribs 44, for example four, that are formed on the press-fit connecting portion side of the flange portion 20.

The first section 42 and second section 43 of the press-fit connecting portion 40 have substantially the same shape, and each of these portions has two or more projecting strips 45 or 46 formed on the outer circumference of the pin. The respective projecting strips 45 and 46 of the first section 42 and second section 43 are formed in mutually different angular positions; for example, the projecting strips 45 and 46 in Figure 1 are formed in a perpendicular relationship.

One example of the first section 42 of the press-fit connecting portion 40 of the press-fit connecting pin 10 is shown in cross-section in Figure 2. This first section 42 in this example has [a] a main body or shaft portion 50 that has circular-arc-formed sections 51, 52 separated by a diameter of approximately 0.4 mm and parallel surfaces 53, 54 separated by a distance of 0.2 mm, and [b] projections 55, 56 that are formed at the approximate centers of the two parallel surfaces 53, 54 and that extend outward in a substantially perpendicular direction (i.e. radially) from these parallel surfaces 53, 54. The projections 55, 56 are formed from base parts 55a, 56a that have a width of 0.1 mm and deformable parts 55b, 56b that have a width of approximately 0.05 mm, which extend outward from the tips of the base parts 55a, 56a (these deformable parts are hereafter referred to as "projecting strips", since these parts correspond to the projecting strips 45, 46 in Figure 1). The tips of the base parts 55a, 56a are positioned on the circumference of a circle having a diameter of approximately 0.4 mm, which is an inner circle having the same diameter as the circle formed by the circular-arc-form parts 51, 52 of the main body part 50. Furthermore, the tips of the projecting strips 55b, 56b are positioned on the circumference of an outer circle with a diameter of approximately 0.56 mm that is centered on the axial center of the main body portion 50.

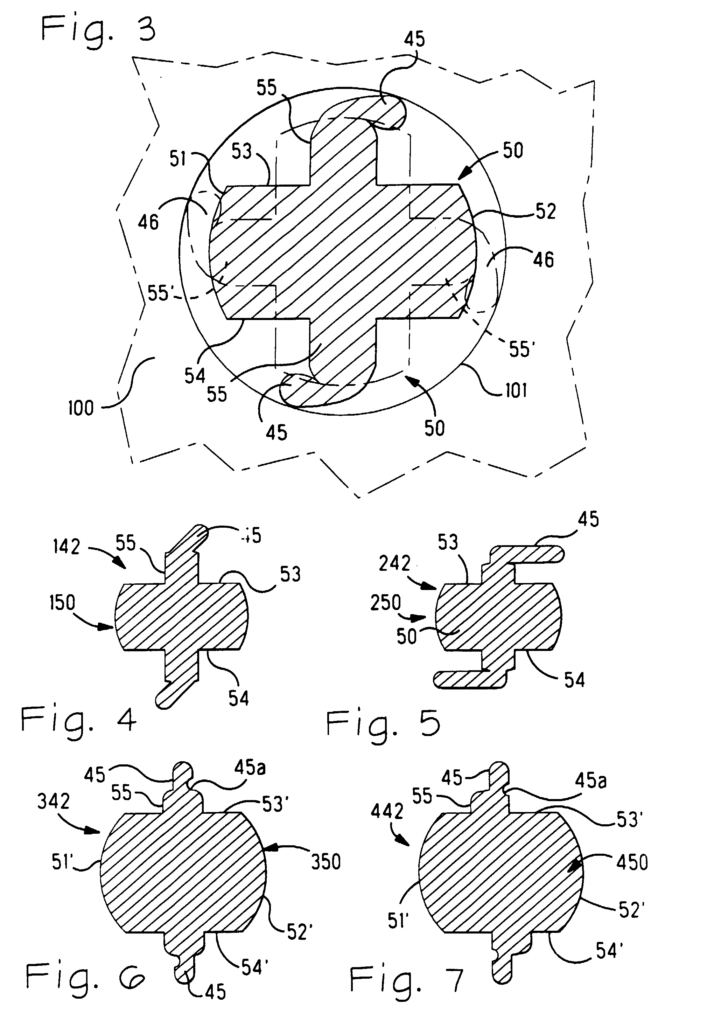

Next, the press-fit connecting pin 10 shown in Figures 1 and 2 will be described with reference to the cross-sectional view shown in Figure 3, which illustrates the press-fitting of the pin 10 in the through-hole 101 of the circuit board 100. Furthermore, in Figure 3, the first section 42 is indicated by a solid line and the second section 43 is indicated by a broken line, thus illustrating the positional relationship of the two sections. Furthermore, the dimensions and shapes of the through-hole 101 in the circuit board 100 and the respective sections of the press-fit connecting portion 40 of the press-fit connecting pin 10 are assumed to be as in the example described above.

As is seen from Figure 3, the inner circle (0.4 mm) formed by the two circular-arc-form parts 51, 52 of the main body part 50 is smaller than the diameter (center value: 0.45mm) of the through-hole 101; accordingly, the main body portion 40 can be inserted without making substantial contact with the inside walls of the through-hole 101. However, since the tips of the projecting strips 55b, 56b are positioned on the circumference of the outer circle described above, which has a diameter of 0.56 mm, the projecting strips 55b, 56b contact the inside walls of the through-hole 101 and are deformed. The amount of deformation depends on the dimensional relationship with the through-hole 101. Furthermore, since the second section 43 of the press-fit connecting portion 40 is in a perpendicular relationship with the first section 42, the projecting strips 45 of the second portion 42 also contact the inside walls of the through-hole 101 and are deformed.

It should be noted here that since the projecting strips of the press-fit connecting pin 10 are deformable, even if the plating layer of the through-hole 101 should be scraped by the projecting strips 45, 46, this scraping will cccur in only a portion of the total length of the plating layer; furthermore, since the projecting strips 45, 46 of the first section 42 and second section 43 are mutually offset, there is no danger of damage to the through-hole 101 (i.e., no danger of a loss of conductivity). Furthermore, it should also be noted that since the projecting strips 45, 46 have a width of approximately 0.05 mm as described above, the insertion force required fcr the insertion of the press-fit connecting pin 10 into the through-hole 101 can be kept at a sufficiently low value.

As best seen in Figure 1, the flange portion 20 of the press-fit connecting pin 10 forms a stop surface with which the pin 10 engages the surface of the circuit board 100. Furthermore, the radial ribs 44 on the outside surface of the flange portion 20 provide gas escape paths when the pin 10 is soldered to the circuit board 100 by surface mount techniques (SMT), such as reflow soldering, so that a good electrical connection is achieved. However, the radial ribs 44 are not an essential part of the present invention and may be omitted depending on the intended use of the pin 10.

The projecting strips 45, 46 of the press-fit connecting pin 10 shown in Figures 1 and 2 are formed radially with respect to the axial center of the main body part 50; accordingly, these projecting strips 45, 46 undergo little deformation during press-fitting in the through-hole 101 of the circuit board 100 and bite into the inside walls of the through-hole 101 as knife edges. However, the projecting strips 45, 46 are not necessarily limited to projecting strips that extend radially, i.e., in directions perpendicular to the parallel surfaces 53, 54. Alternative embodiments of the projecting strips 45, 46 will be described with reference to Figures 4 through 7.

In the alternative embodiments 142, 242 shown in Figures 4 and 5, the dimensions and shapes of the main body part 150, 250 and base parts 55a, 56a are the same as those of the corresponding parts shown in Figure 2. However, these examples are characterized by the fact that the projecting strips 45, 46 (not shown) are inclined at specified angles from the radial direction, so that the overall cross-sectional shape of the projecting strips is roughly an "f" shape.
Specifically, the projecting strips shown in Figure 4 have an angle of inclination of approximately 45 degrees with respect to the radial direction, while the projecting strips shown in Figure 5 are inclined at roughly 90 degrees (i.e., are parallel to the parallel surfaces 53, 54). In both of these alternative embodiments 142, 242, the tips of the projecting strips are positioned on the circumference of an outer circle with a diameter of 0.56 mm as in the case of the projecting strips in Figure 2. It should be noted that the projecting strips in both of these modified examples deform relatively easily and that, when the pin 10 is press-fitted into the through-hole 101 of the circuit board 100, the tips of the projecting strips receive a force that bends the tips inwardly from the circumference of the outer circle along the inside walls of the through-hole 101.
Accordingly, the following advantages are obtained: the insertion force required in order to insert the press-fit connecting pin 10 into the through-hole 101 is small, so that there is little damage to the plating layer on the inside walls of the through-hole 101 and furthermore, a good electrical connection can be obtained with plating layers that show variation as a result of the dimensional tolerance. Next, the alternative embodiments 342, 442 illustrated in Figures 6 and 7 have dimensions and shapes that are slightly different from those of the embodiments of Figures 4 and 5 described above. Here, the circular-arc-form surfaces 51', 52' of the main body part 350, 450 are positioned on the circumference of an inner circle that has a diameter of 0.42 mm and the distance between the parallel surfaces 53', 54' is 0.3 mm.

In the press-fit connecting pin shown in Figure 6 the base parts are formed on the central portions of the parallel surfaces 53', 54' and the tips of these base parts are positioned on the circumference of the inner circle described above. Projecting strips 45 are formed radially in the center of the tip of each base part; however, a semicircular cut-out 45a (e.g., with a radius of approximately 0.015 mm) is formed in the root portion on the right side of each protecting strip 45. As a result of the formation of such cut-outs 45a, a force that causes the projecting strips 45 to bend toward the side in which the cut-out 45a is formed, i.e., to bend in the clockwise direction as shown in these figures, acts on the projecting strips 45 when the pin 10 is press-fitted in the through-hole 101. Accordingly, an effect similar to that obtained with the embodiment shown in Figures 4 and 5 may be expected.

The embodiment shown in Figure 7 is similar to the embodiment shown in Figure 6; however, this embodiment differs from the embodiment shown in Figure 6 in that the base parts 55a, 56a are offset to one side (i.e., the opposite side from the side in which the cut-out 45a is formed). As a result of this shape, the projecting strips 45 have room or space to incline even further in the clockwise direction. Acccordingly, the projecting strips 45 can be sufficiently bent even in the case of a relatively small-diameter through-hole 101 so that press-fitting and connection can be accomplished relatively smoothly without any great damage to the through-hole 101.

The press-fit connection pin 10 of the present invention was described above in detail along with various examples of alternative embodiments. However, the present invention is not limited to such embodiments alone; it goes without saying that various modifications and alterations may be made in accordance with intended uses without departing from the scope of the present invention as defined by the appended claims.

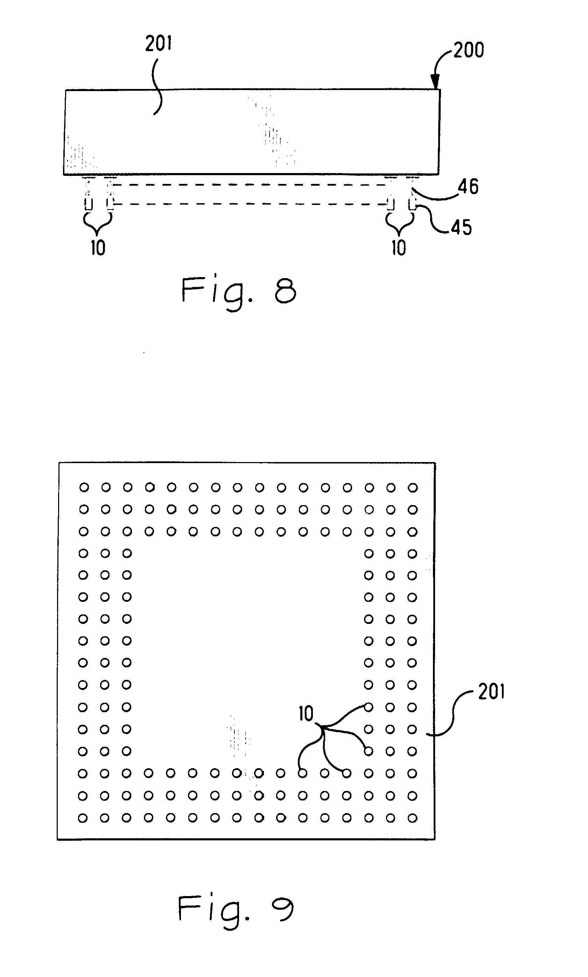

An electronic device using the press-fit connecting pin 10 of the present invention will be briefly described with reference to Figures 8 and 9. Figure 8 is a view of the electronic device 200 and Figure 9 is a bottom view of the same. The electronic device 200 shown here as an example is a device which is commonly known as a "P-PGA" (plastic pin grid array). In this electronic device 200, various types of semiconductor integrated circuits (IC's) and the like are installed and connected on the surface of a plastic substrate and the overall device is sealed with a plastic material (e.g., an epoxy resin). Numerous press-fit connecting pins 10 are disposed in a matrix form on the bottom surface of the main body 201 of the electronic device 200.

The respective press-fit connecting pins 10 may be any of the pins described above with reference to Figures 1 through 7. The cylindrical portions 30 of the pins 10 are connected by welding or the like to conductive pads on the plastic substrate so that the pins 10 are electrically connected to specified circuits of the various IC'S described above. In the case of an electronic device 200 that thus has numerous interconnected pins, it is extremely desirable to use press-fit connecting pins 10 in order to facilitate attachment and connection to the circuit board and for other reasons. In the past, such a need or requirement existed, but no electronic device capable of realizing such connections had been concretely proposed. By using the press-fit connecting pins 10 described above, it has become possible for the first time to realize such connections. Furthermore, it is desirable that the press-fit connecting pins 10 be made of a good conductor of electricity and heat, such as a copper alloy or the like.

As is seen from the above description, the use of the press-fit connecting pin of the present invention makes it possible, as a result of the special construction of the pin to insert the pin into the through-hole of a circuit board by means of a low insertion force, so that damage to the plating layer on the inside walls of the through-hole can be alleviated. Furthermore, a sufficiently reliable electrical connection with the through-hole can also be obtained. Furthermore, the pin of the present invention can also be used in cases where the through-holes involved have a relatively large dimensional tolerance (e.g., ± 0.05 mm). Accordingly, the present invention has the conspicuous practical merit of making it possible to connect electronic devices with large numbers of pins installed at a high density to circuit boards.

## Claims

1. A press-fit connecting pin (10) for press-fitting in a plated through-hole (101) formed in a circuit board (100), the pin including a long, slender shaft portion (30) having deformable strips that project from the shaft portion and are disposed thereon at separate locations with respect to one another, the projecting strips being formed so that they can engage the inside walls of the through-hole, and the strips being deformable upon insertion of the pin into the through-hole (101) of the board (100); the press-fit connecting pin being characterized in that:
the shaft portion includes first and second sections (42, 43) formed longitudinally therealong, each section having radially projecting strips (45,46) disposed at different angular locations with respect to the longitudinal axis of the pin (10).

2. A press-fit connecting pin (10) for press-fitting in a plated through-hole formed in a circuit board, the pin including a long, slender shaft portion having deformable strips that project from the shaft portion and are disposed thereon at separate locations with respect to one another, the projecting strips being formed so that they can contact the inside walls of the through-hole, and the strips (45,46) being deformable upon insertion of the pin (10) into the through-hole (101) of the board (100); the press-fit connecting pin being characterized in that:
the shaft portion (30) is substantially round and includes first and second sections (42,43) formed longitudinally therealong, each section (42,43) having radially projecting strips (45,46) disposed at different angular locations with respect to the longitudinal axis of the pin (10);
each section (42,43) includes a pair of opposed substantially parallel surfaces (53,54) formed on two sides thereof; and
the deformable strips (45,46) are formed at the approximate centers of the parallel surfaces and project in a radial configuration outwardly beyond the diameter of the remaining shaft portion.

3. An electronic device (20) which has a plurality of press-fit connecting pins for press-fitting and connecting in plated through-holes, said electronic device being characterized in that
said press-fit connecting pins have the construction described in Claim 1.

4. An electronic device (200) which has a plurality of press-fit connecting pins for press-fitting and connecting in plated through-holes, said electronic device being characterized in that said press-fit connecting pins have the construction described in Claim 2.

## Patentansprüche

1. Preßsitzanschlußstift (10) zum Einpressen in einem in einer Leiterplatte (100) ausgebildeten durchkontaktierten Loch (101), wobei der Stift einen langen, schlanken Schaftteil (30) mit verformbaren Streifen aufweist, die von dem Schaftteil abstehen und daran an voneinander getrennten Stellen angeordnet sind, wobei die abstehenden Streifen so ausgebildet sind, daß sie die Innenwände des durchkontaktierten Lochs in Eingriff nehmen können, und die Streifen bei Einstecken des Stifts in das durchkontaktierte Loch (101) der Platine (100) verformt werden können; wobei der Preßsitzanschlußstift dadurch gekennzeichnet ist, daß:
der Schaftteil einen daran entlang in Längsrichtung ausgebildeten ersten und zweiten Abschnitt (42, 43) aufweist, wobei jeder Abschnitt radial abstehende Streifen (45, 46) aufweist, die bezüglich der Längsachse des Stifts (10) an unterschiedlichen Winkelstellungen angeordnet sind.

2. Preßsitzanschlußstift (10) zum Einpressen in einem in einer Leiterplatte ausgebildeten durchkontaktierten Loch, wobei der Stift einen langen, schlanken Schaftteil mit verformbaren Streifen aufweist, die von dem Schaftteil abstehen und daran an voneinander getrennten Stellen angeordnet sind, wobei die abstehenden Streifen so ausgebildet sind, daß sie die Innenwände des durchkontaktierten Lochs kontaktieren können, und die Streifen (45, 46) bei Einstecken des Stifts (10) in das durchkontaktierte Loch (101) der Platine (100) verformt werden können; wobei der Preßsitzanschlußstift dadurch gekennzeichnet ist, daß:
der Schaftteil (30) im wesentlichen rund ist und einen daran entlang in Längsrichtung ausgebildeten ersten und zweiten Abschnitt (42, 43) aufweist, wobei jeder Abschnitt (42, 43) radial abstehende Streifen (45, 46) aufweist, die bezüglich der Längsachse des Stifts (10) an unterschiedlichen Winkelstellungen angeordnet sind;
an jedem Abschnitt (42, 43) auf zwei Seiten ein Paar entgegengesetzte, im wesentlichen parallele Flächen (53, 54) ausgebildet ist; und
die verformbaren Streifen (45, 46) an ungefähren Mitten der parallelen Flächen ausgebildet sind und in einer radialen Konfiguration über den Durchmesser des übrigen Schaftteils hinaus nach außen abstehen.

3. Elektronische Vorrichtung (20), die mehrere Preßsitzanschlußstifte zum Einpressen und Anschließen in durchkontaktierten Löchern aufweist, wobei die elektronische Vorrichtung dadurch gekennzeichnet ist, daß die Preßsitzanschlußstifte den in Anspruch 1 beschriebenen Aufbau aufweisen.

4. Elektronische Vorrichtung (200), die mehrere Preßsitzanschlußstifte zum Einpressen und Anschließen in durchkontaktierten Löchern aufweist, wobei die elektronische Vorrichtung dadurch gekennzeichnet ist, daß die Preßsitzanschlußstifte den in Anspruch 2 beschriebenen Aufbau aufweisen.

## Revendications

1. Broche de connexion (10) s'emmanchant à force destinée à être emmanchée à force dans un trou métallisé (101) formé dans une carte imprimée (100), la broche comprenant une partie de fût longue et mince (30) présentant des lamelles déformables qui font saillie depuis la partie de fût et sont disposées sur celle-ci à des emplacements séparés les unes par rapport aux autres, les lamelles en saillie étant formées de façon à pouvoir engager les parois intérieures du trou métallisé, et les lamelles étant déformables lors de l'insertion de la broche dans le trou métallisé (101) de la carte (100); la broche de connexion s'emmanchant à force étant caractérisée en ce que:
la partie de fût comprend des première et deuxième sections (42, 43) formées longitudinalement le long de celle-ci, chaque section présentant des lamelles (45, 46) faisant saillie radialement, disposées à des emplacements angulaires différents par rapport à l'axe longitudinal de la broche (10).

2. Broche de connexion (10) s'emmanchant à force destinée à être emmanchée à force dans un trou métallisé formé dans une carte imprimée, la broche comprenant une partie de fût longue et mince présentant des lamelles déformables qui font saillie depuis la partie de fût et sont disposées sur celle-ci à des emplacements séparés les unes par rapport aux autres, les lamelles en saillie étant formées de façon à pouvoir entrer au contact des parois intérieures du trou métallisé, et les lamelles (45, 46) étant déformables lors de l'insertion de la broche (10) dans le trou métallisé (101) de la carte (100); la broche de connexion s'emmanchant à force étant caractérisée en ce que:
la partie de fût (30) est essentiellement ronde et comprend des première et deuxième sections (42, 43) formées longitudinalement le long de celle-ci, chaque section présentant des lamelles (45, 46) faisant saillie radialement, disposées à des emplacements angulaires différents par rapport à l'axe longitudinal de la broche (10);
chaque section (42, 43) comprend une paire de surfaces opposées (53, 54) essentiellement parallèles formées sur deux côtés de celle-ci; et
les languettes déformables (45, 46) sont formées au niveau des centres approximatifs des surfaces parallèles et font saillie, selon une configuration radiale, vers l'extérieur au-delà du diamètre de la partie de fût restante.

3. Dispositif électronique (20) possédant une pluralité de broches de connexion s'emmanchant à force, destinées à être emmanchées à force et à être connectées dans des trous métallisés, ledit dispositif électronique étant caractérisé en ce que lesdites broches de connexion s'emmanchant à force ont la structure décrite à la revendication 1.

4. Dispositif électronique (200) possédant une pluralité de broches de connexion s'emmanchant à force, destinées à être emmanchées à force et à être connectées dans des trous métallisés, ledit dispositif électronique étant caractérisé en ce que lesdites broches de connexion s'emmanchant à force ont la structure décrite à la revendication 2.
